# EUROPÄISCHE PATENTSCHRIFT

(11) **EP 2 000 013 B1**
(45) Veröffentlichungstag und Bekanntmachung des Hinweises auf die Patenterteilung: **13.10.2010**
(21) Anmeldenummer: 07723814.5
(22) Anmeldetag: 30.03.2007
(51) Int. Cl.: H05K 3/42, H05K 3/18, C25D 3/00, C25D 5/00

(54) **ELEKTROLYTISCHES VERFAHREN ZUM FÜLLEN VON LÖCHERN UND VERTIEFUNGEN MIT METALLEN**
ELECTROLYTIC METHOD FOR FILLING HOLES AND CAVITIES WITH METALS
PROCÉDÉ ÉLECTROLYTIQUE PERMETTANT DE REMPLIR DES TROUS ET DES CREUX AVEC DES MÉTAUX

(30) Priorität: 30.03.2006 EP 06090045
(43) Veröffentlichungstag der Anmeldung: 10.12.2008
(73) Patentinhaber: ATOTECH Deutschland GmbH, 10553 Berlin (DE)
(72) Erfinder: REENTS, Bert, 10115 Berlin (DE); ROELFS, Bernd, 10179 Berlin (DE); MAGAYA, Tafadzwa, 10435 Berlin (DE); YOUKHANIS, Markus, 10437 Berlin (DE); WENZEL, René, 13597 Berlin (DE); KIM, Soungsoo, 12207 Berlin (DE)
(74) Vertreter: Beckmann, Claus
(86) Internationale Anmeldenummer: PCT/EP2007/002872
(87) Internationale Veröffentlichungsnummer: WO 2007/112971

(56) Entgegenhaltungen:
- DE-A1- 10 311 575
- DE-A1- 19 545 231
- DE-A1- 19 653 681
- DE-A1-102004 045 451
- DE-C1- 10 209 365
- DE-C1- 19 915 146

## Beschreibung

### Gebiet der Erfindung

Die vorliegende Erfindung betrifft ein elektrolytisches Verfahren zum Füllen von Vertiefungen, Sacklöchern, Mikrosacklöchern und Durchgangslöchern in Substraten mit Metallen. Das Verfahren ist insbesondere geeignet zur Füllung von Sacklöchern in Leiterplatten mit Kupfer. Es ist jedoch auch geeignet, andere Vertiefungen mit Metallen, insbesondere Kupfer, aufzufüllen. Das Verfahren liefert haltbare Füllungen auch bei kleinen Lochdurchmessern, unerwünschte Einschlüsse im Durchgangsloch können vierhindert werden. Außerdem besitzt die Füllung eine sehr gute Wärmeleitfähigkeit.

### Stand der Technik

Die zunehmende Miniaturisierung von elektronischen Bauelementen führt gleichzeitig zur Zunahme der Integrationsdichte. Bei Leiterplatten spiegelt sich der Trend zur Miniaturisierung in folgenden Konstruktionsparametem: Reduktion von Paddurchmesser und leiterbreite / Leiterabstand sowie einer verbesserten Registrierung und einer Erhöhung der Lagenzahl.

Man bezeichnet Leiterplatten mit diesen Eigenschaften im Allgemeinen als Leiterplatten mit hoher Integrätionsdichte (sogenannte High Density Interconnection oder HDI).

Ein wichtiger Aspekt bei solchen HDI-Schaltungen in der Leiterplattentechnik ist das Füllen von Durchgangslöchern (sogenannten Via-Holes) sowie Sacklöchern. Sacklöcher werden ab bestimmten Dimensionen auch als µ-Blind-Vias (µ-BVs) bezeichnet. Solche µ-BVs oder Mikro-Sacklöcher dienen dazu, mindestens zwei Lagen in Leiterplatten untereinander elektrisch zu verbinden. Von µ-BVs spricht man dann, wenn der Lochdurchmesser der Vias kleiner als 0,15 mm (nach IPC) oder die Lochdichte größer als 1000 Vias/dm³ ist. Der Begriff Sacklöcher wird im Folgenden als Oberbegriff verwendet und schließt µ-BVs mit ein.

Das Füllen der Durchgangslöcher oder Sacklöcher stellt erhebliche Anforderungen an die Prozessführung. Es muss die unterschiedlichsten Arten von Bohrlöchern berücksichtigen, den verschiedenen Anforderungen an die Füllmaterialien genügen und die nachgelagerten Bearbeitungsschritte bei einer Leiterplatte berücksichtigen.

Die vorliegende Erfindung beschreibt schwerpunktmäßig das Füllen von Durchgangeslöchern in Leiterplatten, die durch die gesamte Platte gehen (Plated Through Hole, PTH) und von innenliegenden Durchkontaktierungen (Buried Vias) sowie von Sacklöchern.

Das Verfahren ist im Prinzip zum Füllen von Durchgangslöchern und Sacklöchern in verschiedensten Werkstücken geeignet, insbesondere von plattenförmigen. Werkstüecken und plattenförmigen elektrischen Schaltungsträgern, die Durchganglöcher oder Sacklöchern enthaltene.

Das Verschließen der Durchgangslöcher und Sacklöcher ist unter anderem erforderlich, um das Durchsteigen von Loten auf die Bauelemente zu verhindern, eine hohe lntegrationsdichte zu erreichen und die elektrischen Eigenschaften zu verbessern. Bei Mehrschichtleiterplatten kann es beim Auflaminieren der nächsten Aufbaulage zu Einschlüssen (durch Luft, Lösemittel etc.) in den Löchern kommen, die bei späteren thermischen Belastungen zu Aufwölbungen und in der Konsequenz Rissen in der nächsten Lage führen.

Hauptanforderungen an Füllmaterialien für Durchganglöcher Sacklöcher sind deshalb:
- Lösungsmittelfreiheit
- Gute Hafteigenschaften zur Hülse und zum Lötstopplack
- Beständigkeit gegen Prozesschemikalien in nachfolgenden Schritten (zum Beispiel galvanische Metallisierung mit Nickel, Gold oder Zinn).
- Beständigkeit in Hot-air-levelling-Prozessen.

Im Stand der Technik sind verschiedene Verfahren zum Füllen von Durchgangslöchern und Sacklöchern beschrieben.

Im einfachsten Fall werden die Löcher mit einem speziell eingestellten Lötstopplack gefüllt. Ihr Vorteil ist, dass bei hoher Integratiönsdichte keine Beeinträchtigung in der Auflösung durch den zwangsweise wie ein Nietenkopf überstehenden Durchsteigerfüller gegeben ist. Von Nachteil ist allerdings die Gefahr von Lösemitteleinschlüssen, die bei nachfolgenden Prozessschritten wie einer Verzinnung schlagartig verdampfen können und dabei die Abdeckung aufreißen.

Für das Verschließen von Durchgangslöchern in Innenlagen ist diese Methode allerdings ungeeignet. Hier müssen die Innenlagen vollständig verschlossen werden, um Einschlüsse zu verhindern. Für diesen Prozess ist das Plugging weit verbreitet, denn dieses Verfahren ermöglicht es, durch eine Verkupferung des gefüllten Durchgangslochs eine Innenlage zu erzeugen, die ohne Einschränkung strukturiert werden kann.

Als Füllmaterial werden verschiedene Dielektrika wie zum Beispiel haribeschichtete Kupferfolien (Resin Coated Copper Foils, RCC) oder photodielektrische Flüssig- oder Trockenfilme verwendet.

Die EP 0645 950 B1 beschreibt ein Verfahren zur Herstellung mehrschichtiger Schaltungssubstrate. Als Füllmaterial für Durchgangslöcher werden wärmehärtbare Harze verwendet, die aus der Gruppe gewählt sind, die aus Phenolharz und Epoxidharz besteht. Ferner wird dem Harz als eine leitfähige Substanz mindestes ein Metallpulver beigegeben, das aus der Gruppe gewählt ist, die aus Silber, Nickel, Kupfer und einer Legierung daraus besteht.

Das Pluggen erfolgt in der Regel, nachdem die Leiterplatte gebohrt und die Bohrlöcher abschließend metallisiert worden sind, aber noch vor der Strukturierung. Nach dem Füllen der Durchkontaktierungen und dem Aushärten der Plugging-Paste wird diese mechanisch eingeebnet, da sie durch den-Verfüllvorgang einen leichten Nietenkopf aufweist. Oft erfolgt anschließend eine Metallisierung der Paste mit Kupfer, so dass eine durchgängige Kupferlage als Abschluässchicht erzeugt wird. Vereinfachend sind die folgenden Schritte erforderlich.
- Bohren
- Metallisieren der Hülse
- Pluggen
- Bürsten, Schleifen
- Metallisieren der Plugging-Paste
- Aufbringen der nächsten Aufbaulage.

Die EP 1 194 023 A1 beschreibt die Herstellung von HDI-Leiterplatten durch Füllen von Durchgangslöchern mit leitfähigen Pasten, wobei das Härten der Paste gleichzeitig mit der Verpressung des Basismaterials erfolgen kann, wodurch ein elektrischer Kontakt innenliegender Lagen erzeugt wird.

Andere Verfahren füllen die Durchgangslöcher und Sacklöcher durch Metallisierung mit Kupfer.

Die EP 1 264 918 A1 beschreibt ein Verfahren zur elektrolytischen Abscheidung von Kupfer, das besonders zur Füllung von µ-Blind-Vias geeignet ist. Die Verwendung von inerten Anoden in einer Dummyplatingphase führt hier zur Beibehaltung und Verbesserung der Füllfähigkeit des Elektrolyten.

Gemäß EP 1 219 729 A1 werden chemische Substanzen wie Formaldehyd aber auch Oxidationsmittel verwendet, um die Lebensdauer des Metallisierungsbades zu verlängern, das besonders zur Füllung von µ-Blind-Vias geeignet ist. Als Additive werden dabei schwefelhaltige Substanzen mit Sulfonsäuregruppen sowie Thiol-reaktive Verbindungen verwendet.

Die DE 103 25 101 beschreibt ein Verfahren zum Füllen von µ-Blind-Vias, gekennzeichnet durch die folgenden Stufen:
(i) Verwendung eines Bad-Elektrolyten zur galvanischen Beschichtung mit metallischen überzügen, umfassend Metallsalze, Säuren und organische Zusätze, wobei das Bad eine anorganische Matrix umfassend 15-60 g/l Kupfer, 40-300 g/l Schwefelsäure und 20-150 mg/l Chlorid enthält und die organischen Zusätze Glanzbildner, Netzmittel und weitere Zusätze ausgewählte aus Polyamiden, Polyaminen, Lactamalkoxylaten, Thioharnstoffen, oligomeren und polymeren Phenazoniumderivaten und Aminotriphenylmethan-Farbstoffen umfassen,
(ii) betrieb des Bades mit Gleichstrom bei einer Stromdichte von 0,5-2,5 A/dm² oder Strompülsen mit einer effektiven Stromdichte von 0,5-10 A/dm²;
(iii) Entnahme eines Teils des Elektrolyten aus dem galvanischen Bad,
(iv) Zugabe eines Oxidationsmittels zu dem entnommenen Teil,
(v) gegebenenfalls Bestrahlen des entnommenen Elektrolyten mit UV-Licht und
(vi) Rückführen des entnommenen Teils in das galvanische Bad und Ergänzen der durch die Oxidationsbetiandlung zerstörten organischen Zusätze.

Bei der konventionellen Metallisierung von Löchern beispielsweise in Leiterplatten wird zunächst eine annähernd gleiche Streuung an den Enden der Löcher sowie ihrer Mitte beobachtet. Während der Metallabscheidung ändert sich das Aspektenverhältnis und im Bohrloch wird die Streuung geringer. Dies führt zur vermehrten Metallabscheidung an den Bohrlochenden, die zuwachsen, bevor der Innenraum füllend metallisiert ist. In den Löchern bleiben dann unerwünschte Einschlüsse zurück, insbesondere Reste des Metallisierungsbades.

Außerdem tritt das Problem auf, dass nicht nur die Löcher metallisiert werden, sondern auch die Substratoberfläche metallisiert wird. Dies ist unerwünscht und beeinträchtigt den Prozess erheblich.

### Zusammenfassung der Erfindung

Der vorliegenden Erfindung liegt daher die Aufgabe zugrunde, ein Verfahren zur Füllung von Vertiefungen, Durchgangslöchern und Sacklöchern bzw. Mikrosacklöchern bereitzustellen, bei dem die Metallabscheidung bevorzugt in den Löchern und nicht auf der Substratoberfläche erfolgt.

Diese Aufgabe kann überraschend dadurch gelöst werden, dass in dem Metallisierungsbad ein Redoxsystem (d.h. ein Fe^{2+/3+}-System) eingesetzt wird, wodurch die Metallabscheidung überraschenderweise bevorzugt in den Vertiefungen, Durchgangslöchern und sacklöcher bzw. Mikrosacklöchern erfolgt.

In der Leiterplattentechnik, einem bevorzugten Anwendungsgebiet der vorliegenden Erfindung, werden diese Löcher mit Metall aufgefüllt.

### Beschreibung der Abbildungen der Zeichnungen

Die Abbildungen 1a und 1b zeigen die Bildung einer Verengung durch bevorzugtes Verkupfern in der Mitte eines Durchgangsloches in einer Leiterplatte.

Die Abbildung 2 zeigt ein aufgefülltes Durchgangsloch nach Bildung einer Verengung in der Lochmitte und anschließendem Füllen derselben.

Die Abbildung 3 zeigt ein Pulsumkehrstromdiagramm mit Phasenverschiebung und Pulspause.

Die Abbildung 4 zeigt eine schematische Darstellung einer Vorrichtung, die zum Behandeln von Werkstücken im Tauchverfahren geeignet ist.

Die Abbildungen 5a und 5b zeigen die Abscheidung von Kupfer in einem Sackloch und auf der Oberfläche einer Leiterplatte aus einem Bad mit unterschiedlichen Gehalten an Fe(III).

### Beschreibung bevorzugter Ausführungsformen der Erfindung

In einer bevorzugten Ausführungsform der vorliegenden Erfindung dient das Verfahren dem Füllen von Durchgangslöchern in Leiterplatten mit einer maximalen Höhe von 3,5 mm, einer bevorzugten Höhe von 0,025-1 mm und einer besonders bevorzugten Höhe von 0,05 - 0,5 mm sowie einem Durchmesser von maximal 1000 µm, bevorzugt 30 - 300 µm und besonders bevorzugt von 60 -150 µm.

Bei dem erfindungsgemäßen Verfahren zum Füllen von Durchgangslöchern eines Werkstückes mit Metallen kann im Prinzip jeder für die galvanische Metallabscheidung geeignete Elektrolyt zum Einsatz kommen, wie beispielsweise Elektrolyte zur Abscheidung von Gold, Zinn, Nickel oder Legierungen derselben, Bevorzugt wird Kupfer als Metall verwendet. Der Elektrolyt kann beispielsweise die oben genannte Zusammensetzung gemäß DE 103 25 101 aufweisen und zusätzlich das Fe(II) / Fe (III)-Redoxsystem.

Es hat sich herausgestellt, dass zur Abscheidung von Kupfer verwendete Elektrolyte mit folgender Zusammensetzung die besten Ergebnisse liefern:
Kupfer kann als Kupfersulfatpentahydrat (CuSO₄ x 5H₂O) oder als Kupfersulfatlösung in den Elektrolyten gegeben werden. Der Arbeitsbereich liegt zwischen 15 - 75 g/l Kupfer.

Schwefelsäure (H₂SO₄) wird als 50 - 96% Lösung zugegeben. Der Arbeitsbereich liegt zwischen 20 - 400 g/l, vorzugsweise 50 - 300 g/l.

Chlorid wird als Natriumchlorid (NaCl) oder als Salzsäurelösung (HCl) zugegeben. Der Arbeitsbereich von Chlorid liegt hier zwischen 20-200 mg/l, vorzugsweise 30-60 mg/l.

Des Weiteren umfasst der Elektrolyt vorzugsweise Glanzbildner, Einebner und Netzmittel als organische Zusatzstoffe.

Netzmittel sind üblicherweise sauerstoffhaltige, hochmolekulare Verbindungen in Konzentrationen von 0,005-20 g/l, vorzugsweise 0,01-5 g/l. Beispiele sind in der Tabelle 1 angegeben:

| **Tabelle 1** |
|---|
| **Netzmittel** |
| Carboxymethylcellulose |
| Nonylphenol-polyglykolether |
| Octandiol-bis-(polyalkylenglykolether) |
| Octanolpolyalkylenglykolether |
| Ölsäure-polyglykolester |
| Polyethyleriglykol-polypropylenglykol |
| Copolymerisat) |
| Polyethylenglykol |
| Polyethylenglykol-dimethylether |
| Polypropylenglykol |
| Polyvinylalkohol |
| β-Naphthol-polyglykolether |
| Stearinsäure-potygtykötester |
| Stearylalkohol-polyglykolether |

Als Glanzbildner werden im allgemeinen schwefelhaltige Substanzen verwendet, die in der Tabelle 2 aufgelistet sind:

| **Tabelle 2** |
|---|
| **Schwefelverbindungen** |
| 3(Benzthiazolyl-2-thio)-propylsulfonsäure, Natriumsalz |
| 3-Mercaptopropan-1-sulfonsäure, Natriumsalz |
| Ethylendithiodipropylsulfonsäure, Natriumsalz |
| Bis-(p-sülfophenyl)-disulfid, Dinatriumsalz |
| Bis-(ω-sulfobutyl)-disulfid, Dinatriumsalz |
| Bis-(ω-sulfohydroxypropyl)-disulfid, Dinatriumsalz |
| Bis-(ω-sulfopropyl)-disulfid, Dinatriumsalz |
| Bis-(ω-sulfopropyl)-sulfid, Dinatriumsalz |
| Methyl-(ω-sulfopropyl)-disulfid, Dinatriumsalz |
| Methyl-(ω-sulfopropyl)-trisulfid, Dinatriumsalz |
| O-Ethyl-dithiokohlensäure-S-(ω-sulfopropyl)-ester, Kaliumsalz |
| Thioglykolsäure |
| Thiophosphorsäure-O-ethyl-bis-(ω-sulfopropyl)-ester, Dinatriumsalz |
| Thiophosphorsäure-tris-(ω-sulfopropyl)-ester, Trinatriumsalz |

Als Einebner können polymere Stickstoffverbindungen (z.B. Polyamine oder Polyamide) oder stickstoffhaltige Schwefelverbindungen z.B. Thioharnstoffderivate oder Lactamalkoxylate, wie in Patent DE 38 36 521 C2 beschrieben, verwendet werden. Die Konzentrationen der verwendeten Substanzen liegen in einem Bereich von 0,1-100 ppm.

Des Weiteren können auch polymere Phenazoniumderivate, die in dem Patent DE 41 26 502 C1 beschrieben sind, verwendet werden. Weitere Substanzen, die für das Füllen von Sacklöchern verwendet werden, sind Farbstoffe auf Basis einer Aminotriphenylmethansiruktur wie beispielsweise Malachitgrün, Rosalinin oder Kristallviolett.

Als Anoden können beispielsweise inerte Anoden verwendet werden. Auch lösliche Anoden sind im Prinzip möglich.

Es hat sich nun gezeigt, dass die Verwendung eines Redoxsystems (d.h. eines Fe^{2+/3+}-Systems) überraschenderweise dazu führt, dass die Metallabscheidung bevorzugt in den Vertiefungen, Durchgangslöchern und Sacklöchern erfolgt.

Konzentrationen: Fe (II): mindestens 1 g/l, bevorzugt 2-25 g/l.

Fe(III): 6-30 g/l, bevorzugt 6-15, mehr bevorzugt 6-9 g/l und besonders bevorzugt 6-8 g/l.

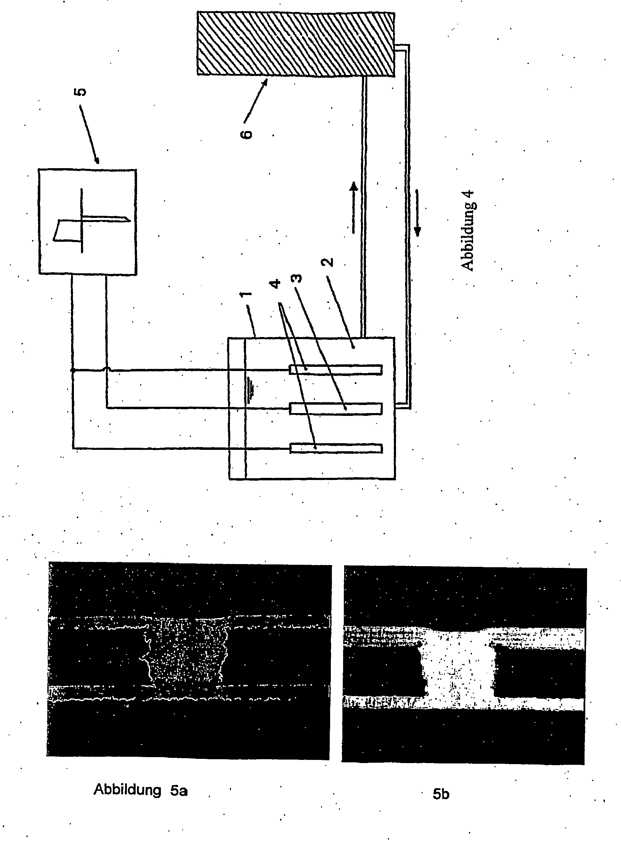

Eine typische Anordnung, die zum Behandeln der Werkstücke im Tauchverfahren geeignet ist, ist in Abbildung 4 schematisch dargestellt im Behälter 1 befindet sich die Abscheidelösung 2, die Verbindungen des elektröchemisch reversiblen Redoxsystems enthält (Eisen(II)- und Eisen-(III)-ionen). Die Abscheidelösung kann beispielsweise zur Verkupferung dienen und enthält dann die zuvor angegebenen Bestandteile. In die Abscheidelösung tauchen die Werkstücke 3, beispielsweise Leiterplatten, und die Anoden 4, beispielsweise mit Iridiumoxid beschichtete Titananoden, ein. Die Werkstücke und die Anoden sind mit der Stromquelle 5 verbunden. Anstelle einer Regelung des Stromes mit der Stromquelle kann auch eine Spannungsversorgung vorgesehen serin, mit der die Spannung zwischen den Werkstücken und den Anoden geregelt wird. Die Abscheidelösung wird fortwährend mittels nicht dargestellter Fördereinrichtungen, beispielsweise Pumpen, zu einem zweiten Behälter 6 geführt.

In diesem separaten Behältnis, dem Metaitionen-Generator, der von der Abscheidelösung durchflossen wird, wird das Metall in der Abscheidelösung wieder ergänzt. Im Metallionen-Generatör befinden sich im Falle der Kupferabscheidung metallische Kupferteile, beispielsweise in Form von Stücken, Kugeln oder Pellets. Die Kupferteile lösen sich unter der Wirkung der oxidierten Form der Redoxverbindungen zu Kupferionen auf. Durch die Auflösung der Kupferteile wird die oxidierte. Form des Redoxsystems in die reduzierte Form überführt. Die mit Kupferionen und der reduzierten Form angereicherte Lösung wird mittels der nicht dargestellten Pumpen zum ersten Behälter wieder zurückgeführt. Das für die Regenerierung verwendete metallische Kupfer braucht Phosphor nicht zu enthalten, jedoch stört Phosphor auch nicht. Beim herkömmlichen Einsatz von löslichen Kupferanoden ist die Zusammensetzung des Anodenmaterial hingegen von großer Bedeutung: In diesem Fall müssen die Kupferanoden etwa 0,05 Gew.-% Phosphor enthalten. Derartige Werkstoffe sind teuer, und der Phosphorzusatz verursacht Rückstände in der elektrolytischen Zelle, die durch zusätzliche Filterung zu entfernen sind.

Entscheidend ist die ausreichend hohe Konzentration von Fe(III)ionen, die im Stand der Technik bisher nicht beschrieben ist.

Für saure Kupfer-, DC- und AC-Elektrolyte können auch lösliche Anoden zum Einsatz kommen.

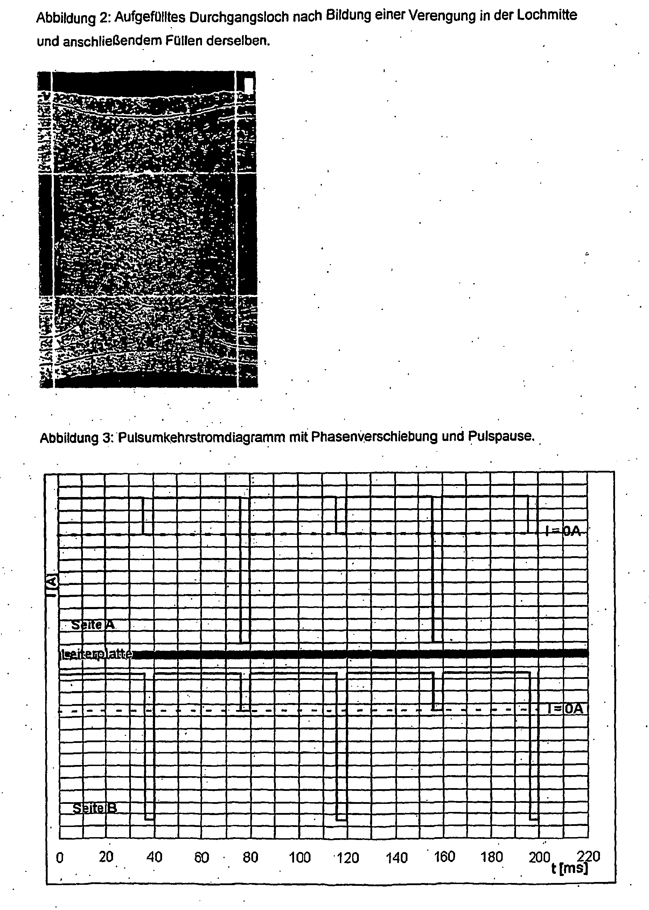

Des Weiteren hat sich herausgestellt, dass die Füllung mit Metallen insbesondere bei horizontalen Verfahren besonders gute Ergebnisse unter Verwendung einer speziellen Art der Metallisierung mittels eines Pulsumkehrstroms liefert. Diese besondere Technik zeichnet sich durch eine Phasenverschiebung von 180° zwischen den beiden, durch zwei getrennte Pulsgleichrichter erzeugte Pulsformen aus. Mittels der beiden Gleichrichter können die zwei Seiten einer Leiterplatte getrennt metallisiert werden. Eine weitere Besonderheit besteht in der Verwendung einer sich periodisch wiederholenden Pulspause für beide Gleichrichter, welche so gewählt wird, dass zur gleichen Zeit der Rückwärts- oder Reverse-Strompuls auf der anderen Seite wirkt, siehe Abbildung 3.

Das Reverse-Pulse-Plating wurde für die elektrolytische Abscheidung insbesondere von Kupfer auf Leiterplatten mit einem hohen Aspektverhältnis entwickelt und ist beispielsweise in DE 42 25 961 C2 und DE 27 39 427 A1 beschrieben. Durch die Verwendung von hohen Stromdichten wird eine verbesserte Oberflächenverteilung und Streuung in den Durchgangslöchern erreicht.

Bei dem erfindungsgemäßen Verfahren werden bevorzugt die folgenden Parameter eingestellt:
Das Verhältnis der Dauer des mindestens einen Vorwärts-Strom pulses zur Dauer des mindestens einen Reverse-Strompulses wird auf mindestens 5, vorzugsweise auf mindestens 15 und weiter bevorzugt auf mindestens 18 eingestellt. Dieses Verhältnis kann bis auf höchstens 100 und vorzugsweise auf höchstens 50 eingestellt werden. Besonders bevorzugt wird das Verhältnis auf etwa 20 eingestellt.

Die Dauer des mindestens einen Vorwärts-Strompulses kann auf mindestens 5 ms bis 250 ms, vorzugsweise 20-240 ms und besonders bevorzugt 80-160 ms eingestellt werden.

Die Dauer des mindestens einen Reverse-Strompulses wird auf höchstens 20 ms, bevorzugt 1-10 ms, mehr bevorzugt 1-8 ms und besonders bevorzugt 4-5 ms eingestelle.

Die Peak-Stromdichte des mindestens einen Vorwärts-Strom pulses am Werkstück wird bevorzugt auf einen Wert von höchstens 15 A/dm² eingestellt werden. Bevorzugt beträgt die Peak-Stromdichte des mindestens einen Vorwärts-Strompulses am Werkstück etwa 1,5 - 8 A/dm² bei horizontalen Verfahren, besonders bevorzugt 7-8 A/dm². Bei vertikalen Verfahren beträgt die besonders bevorzugte Peak-Stromdichte des windestens einen Vorwärts-Strompulses am Werkstück maximal 2 A/dm².

Die Peak-Stromdichte des mindestens einen Reverse-Strompulses am Werkstück wird bevorzugt auf einen Wert von höchstens 60 A/dm² eingestellt werden. Bevorzugt beträgt die Peak-Stromdichte des mindestens einen Reverse-Strompulses am Werkstück etwa 30 - 50 A/dm², besonders bevorzugt 30-40 A/dm² bei horizontalen Verfahren. Bei vertikalen Verfahren beträgt die besonders bevorzugte Peak-Stromdichte des mindestens einen Vorwärts-Strompulses am Werkstück maximal 3 - 10 A/dm².

Die Pulspause beträgt im Allgemeinen in Abhängigkeit vom Reverse-Pulsparameter und der Phasenverschiebung 0-8 ms.

Die Phasenverschiebung beträgt 0°-180°, bevorzugt 0° oder 180°.

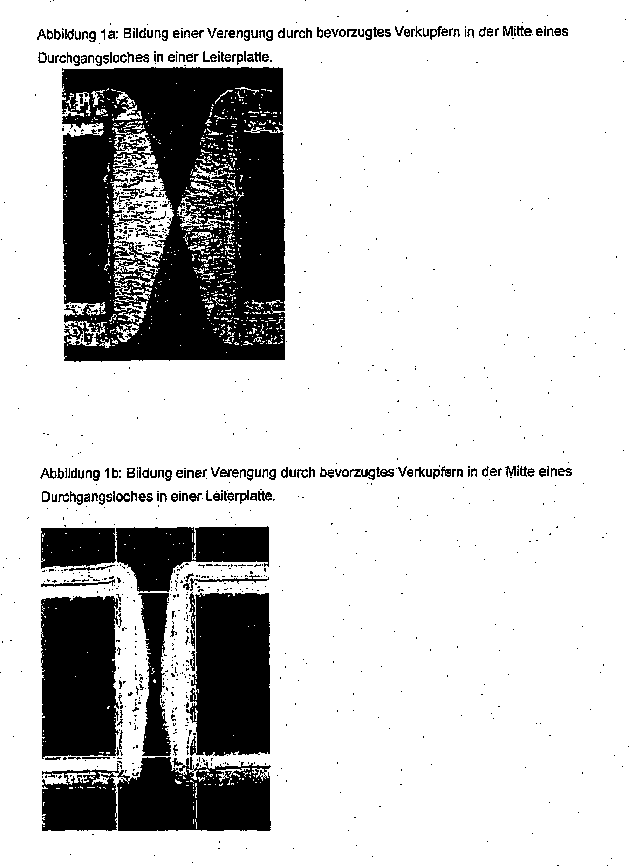

Eine Variante des Verfahrens zum Füllen von Vertiefungen, Durchganglöchern und Sacklöchern eines Werkstückes mit Metallen umfasst die folgenden Verfahrensschritte:
(i) In-Kontakt-Bringen des Werkstücks enthaltend Durchgangslöcher mit einem Metallabscheide-Elektrolyten und Anlegen einer Spannung zwischen dem Werkstück und mindestens einer Anode, so dass dem Werkstück ein Stromfluss zugeführt wird, wobei der Stromfluss so gewählt wird, dass gemäß Abbildung 1 a und b eine bevorzugte Abscheidung in der Mitte der Durchgangslöcher erfolgt und die Durchgangslöchet in Folge dessen vollständig oder annähernd vollständig zusammenwachsen;
(ii) Weiteres In-Kontakt-Bringen des Werkstücks mit einem Metallabscheide-Elektrolyten und Anlegen einer Spannung zwischen dem Werkstück und mindestens einer Anode, so dass dem Werkstück ein Stromfluss zugeführt wird, wobei die gemäß Stufe (i) erhaltenen vollständig oder annähernd vollständig in zwei Hälften geteilten Durchgangslöcher bis zum gewünschten Grad gemäß Abbildung 2 durch das Metall aufgefüllt werden.

Durch Anwendung des erfindungsgemäßen zweistufigen Verfahrens wird erstmals eine Möglichkeit geschaffen, ein Durchgangsloch mit einer reinen Metallschicht zu füllern. Die im Stand der Technik beschriebenen Verfahren zum Füllen verwenden Pasten - meist leitfähig - da bisher die Auffassung herrschte, dass die Herstellung einer kompakten Metallschicht nicht mit der erforderlichen Haltbarkeit und den gewünschten Eigenschaften möglich ist.

In einer bevorzugten Ausführungsform der vorliegenden Erfindung umfasst das Verfahren die folgenden Verfahrensschritte:
a. eine erste Spannung wird zwischen einer ersten Seite des Werkstücks und mindestens einer ersten Anode angelegt, so dass der ersten Seite des Werkstücks ein erster Pulsumkehrstrom zugeführt wird, wobei in jedem Zyklus dieses ersten Pulsumkehrstroms mindestens ein erster Vorwärts-Strom puls und mindestens ein erster Reverse-Strompuls fließen.
b. eine zweite Spannung wird zwischen einer zweiten Seite des Werkstücks und mindestens einer zweiten Anode angelegt, so dass der zweiten Seite des Werkstücks ein zweiter Pulsumkehrstrom zugeführt wird, wobei in jedem Zyklus dieses zweiten Pulsumkehrstroms mindestens ein zweiter Vorwärts-Strompuls und mindestens ein zweiter Reverse-Strompuls fließen.
c. Das Werkstück ist dabei mit einem Elektrolyt in Kontakt, welcher das Redoxsystem beinhaltet (Fe^{2+/3+} - System).

Konzentrationen: Fe (II): mindestens 1 g/l, bevorzugt 2-25 g/l.

Fe(III): 6-30 g/l, bevorzugt 6-15, mehr bevorzugt 6-9 g/l und besonders bevorzugt 6-8 g/l.

Was diese letztere Ausführungsform angeht, so können der mindestens eine erste Vorwärts-Strompuls bzw. der mindestens, eine erste Reverse-Strompuls zu dem mindestens einen zweiten Vorwärts-Strompuls bzw. zu dem mindestens einen zweiten Reverse-Strompuls versetzt sein. In einer weiter bevorzugten Ausführungsform der vorliegenden Erfindung beträgt dieser Versatz zwischen den ersten und den zweiten Strompulsen etwa 180°.

Zur weiteren Verbesserung der Streuung kann der Stromfluss in jedem Zyklus zwei Vorwärts-Strompulse umfassen, wobei zwischen den zwei Vorwärts-Strompulsen und einem Reverse-Strompuls eine Nullstromunterbrechung vorgesehen ist.

Im weiteren Verlauf des Metallisierungsprozesses kann mindestens ein Parameter des Pulsumkehrstroms variiert werden, wobei dieser Parameter ausgewählt, ist aus einer Gruppe, umfassend das Verhältnis der Dauer des Vorwärts-Strompulses zur Dauer des Reverse-Strompulses und das Verhältnis der Peak-Stromdichte des Vorwärts-Strompulses zur Peak-Stromdichte des Reverse-Strompulses. Es hat sich insbesondere als vorteilhaft erwiesen, das Verhältnis der Peak-Stromdichte des Vorwärts-Strompulses zur Peak-Stromdichte des Reverse-Strompulses beim Metallisieren des Werkstücks zu erhöhen und/oder das Verhältnis der Dauer des Vorwärts-Strompulses zur Dauer des Reverse-Strompulses zu verringern.

Die Erfindung wird durch das nachfolgende Beispiel näher erläutert:

### Ausführungsbeispiel 1

Die verwendeten Inpulse 2-Module der Atotech Deutschland GmbH zur horizontalen Behandlung von Leiterplatten (in denen Platten zur Behandlung auf einem horizontalen Weg und in horizontaler Transportebene befördert werden) haben einen Abstand von 15 mm zwischen dem Sprühdüsenstock und der Kathode (Werkstück) und einen Abstand von 8 mm zwischen Anode und Kathode.

Für die Metallisierung wird eine Leiterplatte aus FR4-Material, den Abmessungen 18" x 24" = 457 mm x 610 mm und mit einem Sacklochdurchmesser von 100 µm und einer Tiefe von 70 µm verwendet (Tabellen 2 und 3, jeweils 3. Zeilen von oben), wenn nicht anders angebeben.

Vor der Metallisierung wird die Oberfläche der Leiterplatte zunächst für 45 Sekunden mit dem Reiniger Cuprapro CF der Firma Atotech Deutschland GmbH gereinigt und danach mit 5%iger Schwefelsäure für 45 Sekunden behandelt.

Die verwendeten Elektrolyte besitzen die folgende Zusammensetzung. Die Metallisierung erfolgt in allen Fällen bei einer Temperatur von 40°C.
Kupfer: 70 g/l
Schwefelsäure: 80 g/l
Chloridionen: 40 mg/l
Eisen(II): 12 g/l
Eisen(III): 2-8 g/l
Einebner Inpulse 2HF: 18ml/l; Glanzbildner Inpulse 2: 12 ml/l
Inpulse Einebner und Glanzbildner sind Produkte der Atotech Deutschland GmbH.

Gemäß der oben beschriebenen allegemeinen Durchführungsvorschrift für horizontale Verfahren wird die Leiterplatte für einen in den Tabellen 4 und 5 angegeben Zeitraum in einem Bad zur elektrolytischen Metallisierung mit Kupfer mit dem Inpulse 2HF-Verfahren und einem Pulsumkehrstromverfahren mit den Parametern gemäß Tabelle 3 behandelt. Man erhält eine Abscheidung von Kupfer in den Durchgangslöchern wie in Abbildung 5a dargestellt.

In dem zweiten Versuch wird eine gleiche Leiterplatte in einem Bad zur elektrolytischen Metallisierung mit Kupfer mit dem Inpulse 2HF Verfahren und einem Pulsumkehrstromverfahren mit den Parameters gemäß Tabelle 3 behandelt, diesmal also mit einem deutlich niedrigerem Fe(III) - Gehalt von 3 g/l anstatt 7 g/l. Man erhält eine Abscheidung von Kupfer im Sackloch und auf der Oberfläche gemäß Abbildung 5b.

**Tabelle 3. Pulsparameter bei der Metallisierung mit Kupfer**

| Versuch | I_{vorwärts}/Iᵣₑᵥₑᵣₛₑ in A/dm² | Pulsparameter in ms Vorwärts- / Reverse-Puls | Pulspause in ms | Phasenverschlebung in ° | Kupfer g /l | Fe(III) g/l | Schwefelsäure g / l |
|---|---|---|---|---|---|---|---|
| 10a | 5 / 40 | 80 / 4 | 4 | 0 | 70 | 7 | 80 |
| 10b | 5 / 40 | 80 / 4 | 4 | 0 | 70 | 3 | 80 |

Deutlich erkennbar ist die geringere Abscheidung des Kupfers in Abbildung 5a aufgrund der höheren Konzentration an Eisen(III)-lonen in der Lösung auf der Oberfläche (geringere Schichtdicke Kupfer) im Vergleich zu Abbildung 5b. Dieser Unterschied ist in den Tabellen 4 und 5 für verschiedene Sacklochdimensionen dargestellt (Spalte Abscheidungsmenge):

**Tabelle 4: Verfüllen von Sacklöchern mittels des Inpulse-2HF-Verfahrens bei niedrigem Fe(III)-Gehalt (3 g/l)**

| Sackloch Durchmesser | Sackloch Tiefe | Abscheidungszeit | Abscheidungsmenge | Verbleibende Vertiefung |
|---|---|---|---|---|
| 80 µm | 60 µm | 26 min. | 20 µm | < 10 µm |
| 100 µm | 70 µm | 30 min. | 23 µm | < 10 µm |
| 125 µm | 70 µm | 35 min. | 27 µm | <10 µm |
| 100 µm | 100 µm | 41 min. | 32 µm | <10 µm |

**Tabelle 5: Verfüllen von Sacklöchern mittels des Inpulse-2HF-Verfahrens bei hohem Fe(III)-Gehalt (7 g/l)**

| Sackloch Durchmesser | Sackloch Tiefe | Abscheidungszeit | Abscheidungsmenge | Verbleibende Vertiefung |
|---|---|---|---|---|
| 80 µm. | 60 µm | 22 min. | 12 µm | < 10 µm |
| 100 µm | 70 µm | 27 min. | 15 µm | < 10 µm |
| 125 µm | 70 µm | 30 min. | 17 µm | <10 µm |
| 100 µm | 100 µm | 36 min. | 20 µm | < 10 µm |

## Patentansprüche

1. Galvanisches Verfahren zum Füllen von Vertiefungen, Durchgangslöchern, Sacklöchern oder Mikrosacklöchern eines Werkstückes mit Metallen umfassend das In-Kontakt-Bringen des Werkstücks enthaltend Vertiefungen, Durchgangslöcher, Sacklöcher oder Mikrosacklöcher mit einem Metallabscheide-Elektrolyten und Anlegen einer Spannung zwischen dem Werkstück und mindestens einer Anode, so dass dem Werkstück ein Stromfluss zugeführt wird, **dadurch gekennzeichnet, dass** der Elektrolyt ein Redoxsystem enthält, wobei das Redoxystem ein Fe(II) /Fe (III)-Redoxsystem ist und Fe(II) in einer Konzentration von mindestens 1 g/l und Fe(III) in einer Konzentration von 6-30 g/l enthalten ist.

2. Verfahren nach Anspruch 3, **dadurch gekennzeichnet, dass** Fe(II) in einer Konzentration von 2-25 g/l und Fe(III) in einer Konzentration von 6-15 g/l enthalten ist.

3. Verfahren nach Anspruch 2, **dadurch gekennzeichnet, dass** Fe(III) in einer Konzentration von 6-9 g/l enthalten ist.

4. Verfahrens nach Anspruch 1, **dadurch gekennzeichnet, dass** der Elektrolyt 15-75 g/l. Kupfer, 50-300 g/l H₂SO₄ und 20-200 mg/l Chlorid enthält.

5. Verfahren nach den Ansprüchen 1 bis 3, **dadurch gekennzeichnet, dass** der Fe(III)-Gehalt 6-8 g/l beträgt.

6. Verfahren nach den Ansprüchen 1 bis 4, **dadurch gekennzeichnet, dass** in einer ersten Stufe (i) der Stromfluss so gewählt wird, dass eine bevorzugte Abscheidung in der Mitte der Durchgangslöcher erfolgt und die Durchgangslöcher in Folge dessen vollständig oder annähernd vollständig zusammenwachsen, und in einer weiteren Stufe (ii) ein weiteres In-Köntakt-Bringen des Werkstücks mit einem Metallabscheide-Elektrolyten und Anlegen einer Spannung zwischen dem Werkstück und mindestens einer Anode erfolgt, so dass dem Werkstück ein Stromfluss zugeführt wird, wobei die gemäß Stufe (i) erhaltenen vollständig oder annähernd vollständig in zwei Hälften geteilten Durchgangslöcher durch das Metall aufgefüllt werden,
wobei der Stromfluss gemäß Stufe (i) ein Pulsumkehrstrom ist und in jedem Zyklus des Stromes mindestens ein Vorwärts-Strompuls und mindestens ein Reverse-Strompuls auftritt und dass der Stromfluss gemäß Stufe (ii) entweder ein Pulsumkehrstrom, ein Gleichstrom oder ein Wechselstrom ist, und wobei in Stufe (i) das Verhältnis der Dauer des mindestens einen Vorwärts-Strompulses zur Dauer des mindestens einen Reverse-Strompulses auf 5 - 75, die Dauer des mindestens einen Vorwärts-Strom pulses auf 5 - 250 ms und die Dauer des mindestens einen Reverse-Strompulses auf höchstens 20 ms eingestellt wird.

7. Verfahren nach Anspruch 6, **dadurch gekennzeichnet, dass** die Metallisierungsschritte (i) und (ii) in demselben Elektrolyten durchgeführt werden.

8. Verfahren nach Anspruch 6, **dadurch gekennzeichnet, dass** das Verhältnis der Dauer des mindestens einen Vorwärts-Strompulses zur Dauer des mindestens einen Reverse-Strompulses auf etwa 20 eingestellt wird.

9. Verfahren nach Anspruch 6, **dadurch gekennzeichnet, dass** die Dauer des mindestens einen Reverse-Strompulses auf 1 - 10 ms eingestellt wird.

10. Verfahren nach einem der Ansprüche 6 bis 9, **dadurch gekennzeichnet, dass** die Peak-Stromdichte des mindestens einen Vorwärts-Strompulses am Werkstück auf bevorzugt höchstens 15 A/dm², besonders bevorzugt auf 1,5-8 A/dm² bei horizontalen Verfahren und besonders bevorzugt auf höchstens 2 A/dm² bei vertikalen Verfahren eingestellt wird.

11. Verfahren nach einem der Ansprüche 6 bis 9, **dadurch gekennzeichnet, dass** die Peak-Stromdichte des mindestens einen Reverse-Strompulses am Werkstück auf bevorzugt höchstens 60 A/dm², besonders bevorzugt auf 30 - 50 A/dm² bei horizontalen Verfahren und besonders bevorzugt auf 3 - 10 A/dm² bei vertikalen Verfahren eingestellt wird.

12. Verfahren nach einem der Ansprüche 6 bis 11, **dadurch gekennzeichnet, dass** eine erste Spannung zwischen einer ersten Seite des Werkstücks und mindestens einer ernsten Anode angelegt wird, so dass der ersten Seite des Werkstücks ein erster Pulsumkehrstrom zugeführt wird, wobei in jedem Zyklus dieses ersten Pulsumkehrstroms mindestens ein erster Vorwärts-Strompuls und mindestens ein erster Reverse-Strompuls fließen,
eine zweite Spannung zwischen einer zweiten Seite des Werkstücks und mindestens einer zweiten Anode angelegt wird, so dass der zweiten Seite des Werkstücks ein zweiter Pulsumkehrstrom zugeführt wird, wobei in jedem Zyklus dieses zweiten Pulsumkehrstroms mindestens ein zweiter Vorwärts-Strömpuls und mindestens ein zweiter Reverse-Strompuls fließen.

13. Verfahren nach Anspruch 12, **dadurch gekennzeichnet, dass** die ersten Strompulse zu den zweiten Strompulsen um etwa 180° versetzt werden.

14. Verfahren nach einem der Ansprüche 1 bis 13, **dadurch gekennzeichnet, dass** die Löcher eine maximale Höhe von 3,5 mm, eine bevorzugte Höhe von 0,025 mm - 1 mm und eine besonders bevorzugte Höhe von 0,05 - 0,5 mm aufweisen.

15. Verfahren nach einem der Ansprüche 1 bis 13, **dadurch gekennzeichnet, dass** die Löcher einen Durchmesser von maximal 1000 µm, bevorzugt 30 µm - 300 µm und besonders bevorzugt von 60 µm -150 µm aufweise.

16. Verfahren nach einem der Ansprüche 1 bis 15, **dadurch gekennzeichnet, dass** das Werkstück eine Leiterplatte oder ein anderer plattenförmiger elektrischer Schaltungsträger ist.

## Claims

1. Galvanic method for filling cavities, through holes, blind holes or micro blind holes of a work piece with metals, comprising bringing into contact the work piece containing cavities, through holes, blind holes or micro blind holes with a metal deposition electrolyte and applying a voltage between the work piece and at least one anode such that a current flow is fed to the work piece, **characterized in that** the electrolyte contains a redox system, wherein the redox system is a Fe(II)/Fe(III) redox system and Fe(II) is contained in a concentration of at least 1 g/l and Fe(III) is contained in a concentration of 6-30 g/l.

2. Method according to claim 1, **characterized in that** Fe(II) is contained in a concentration of 2-25 g/l and Fe(III) is contained in a concentration of 6-15 g/l.

3. Method according to claim 2, **characterized in that** Fe(III) is contained in a concentration of 6-9 g/l.

4. Method according to claim 1, **characterized in that** the electrolyte contains 15-75 g/l copper, 50-300 g/l H₂SO₄ and 20-200 mg/l chloride.

5. Method according to any one of claims 1 to 3, **characterized in that** the Fe(III) content amounts to 6-8 g/l.

6. Method according to claims 1 to 4, **characterized in that** the current flow in a first step (i) is selected such that a preferred deposition occurs in the center of the through holes and as a result the through holes grow together completely or almost completely, and in a further step (ii) further bringing into contact the work piece with a metal deposition electrolyte and applying a voltage between the work piece and at least one anode is carried out such that a current flow is fed to the work piece, wherein the through holes obtained according to step (i), which are completely or almost completely divided into two halves, are filled by the metal,
wherein the current flow according to step (i) is a pulse reverse current and at least one forward current pulse and at least one reverse current pulse occurs in each current cycle and that the current flow according to step (ii) is either a pulse reverse current, a direct current or an alternating current, and wherein in step (i) the ratio of the duration of the at least one forward current pulse to the duration of the at least one reverse current pulse is adjusted to 5-75, the duration of the at least one forward current pulse is adjusted to 5-250 ms and the duration of the at least one reverse current pulse is adjusted to 20 ms at the most.

7. Method according to claim 6, **characterized in that** the metallization steps (i) and (ii) are carried out in the same electrolyte.

8. Method according to claim 6, **characterized in that** the ratio of the duration of the at least one forward current pulse to the duration of the at least one reverse current pulse is adjusted to about 20.

9. Method according to claim 6, **characterized in that** the duration of the at least one reverse current pulse is adjusted to 1-10 ms.

10. Method according to any one of claims 6 to 9, **characterized in that** the peak current density of the at least one forward current pulse at the work piece is preferably adjusted to 15 A/dm² at the most, particularly preferred to 1.5-8 A/dm² in horizontal methods and particularly preferred to 2 A/dm² at the most in vertical methods.

11. Method according to any one of claims 6 to 9, **characterized in that** the peak current density of the at least one reverse current pulse at the work piece is preferably adjusted to 60 A/dm² at the most, particularly preferred to 30-50 A/dm² in horizontal methods and particularly preferred to 3-10 A/dm² in verticals methods.

12. Method according to any one of claims 6 to 11, **characterized in that** a first voltage is applied between a first side of the work piece and at least one first anode such that a first pulse reverse current is fed to the first side of the work piece, wherein at least one first forward current pulse and at least one first reverse current pulse flow in each cycle of said first pulse reverse current,
a second voltage is applied between a second side of the work piece and at least one second anode such that a second pulse reverse current is fed to the second side of the work piece, wherein at least one second forward current pulse and at least one second reverse current pulse flow in each cycle of said second pulse reverse current.

13. Method according to claim 12, **characterized in that** the first current pulse is shifted with respect to the second current pulse by about 180°.

14. Method according to any one of claims 1 to 13, **characterized in that** the holes have a maximum height of 3.5 mm, a preferred height of 0.025 mm - 1 mm and a particularly preferred height of 0.05 - 0.5 mm.

15. Method according to any one of claims 1 to 13, **characterized in that** the holes have a diameter of 1000 µm at the most, preferably 30 µm - 300 µm and particularly preferred 60 µm - 150 µm.

16. Method according to any one of claims 1 to 15, **characterized in that** the work piece is a circuit board or another electric circuit support in board form.

## Revendications

1. Procédé galvanique pour le remplissage de creux, trous de passage, trous borgnes ou microtrous borgnes d'une pièce à usiner avec des métaux, comprenant la mise en contact de la pièce à usiner contenant des creux, trous de passage, trous borgnes ou microtrous borgnes avec un électrolyte de dépôt de métal et imposition d'une tension entre la pièce à usiner et au moins une anode, de sorte que la pièce à usiner soit traversée d'un courant, **caractérisé en ce que** l'électrolyte contient un système rédox, sachant que le système rédox est un système rédox Fe (II)-Fe (III) et que Fe (II) est présent en une concentration d'au moins 1 g/litre et Fe (III) en une concentration de 6-30 g/litre.

2. Procédé selon la revendication 1, **caractérisé en ce que** Fe (II) est présent en une concentration de 2-25 g/litre et Fe (III) en une concentration de 6-15 g/litre.

3. Procédé selon la revendication 2, **caractérisé en ce que** Fe (III) est présent en une concentration de 6-9 g/litre.

4. Procédé selon la revendication 1, **caractérisé en ce que** l'électrolyte contient 15-75 g/litre de cuivre, 50-300 g/litre de H₂SO₄ et 20-200 mg/litre de chlorure.

5. Procédé selon les revendications 1 à 3, **caractérisé en ce que** la teneur en Fe (III) se situe dans l'intervalle allant de 6 à 8 g/litre.

6. Procédé selon les revendications 1 à 4, **caractérisé en ce que** dans une première étape (i), le courant est choisi de sorte qu'un dépôt préféré au milieu des trous de passage est réalisé et que le dépôt croit progressivement ensuite, complètement ou sensiblement complètement, et **en ce que** dans une deuxième étape (ii), une autre mise en contact de la pièce à usiner avec un électrolyte de dépôt de métal et imposition d'une tension entre la pièce à usiner et au moins une anode sont réalisées, de sorte que la pièce à usiner soit traversée d'un courant, sachant que les trous de passage divisés complètement ou sensiblement complètement en deux moitiés, obtenus selon l'étape (i), sont remplis par le métal,
sachant que le courant selon l'étape (i) est un courant pulsé inversé et que dans chaque cycle du courant, au moins une impulsion avant et au moins une impulsion inverse se produisent et que le courant selon l'étape (ii) est un courant pulsé inversé, un courant continu ou un courant alternatif, et sachant qu'à l'étape (i), le rapport de la durée de la au moins une impulsion avant par rapport à la durée de la au moins une impulsion inverse est ajusté à 5-75, la durée de la au moins une impulsion avant à 5-250 ms et la durée de la au moins une impulsion inverse à maximum 20 ms.

7. Procédé selon la revendication 6, **caractérisé en ce que** les étapes (i) et (ii) de métallisation sont réalisées dans les mêmes électrolytes.

8. Procédé selon la revendication 6, **caractérisé en ce que** le rapport de la durée de la au moins une impulsion avant par, rapport à la durée de la au moins une impulsion inverse est ajusté à environ 20.

9. Procédé selon la revendication 6, **caractérisé en ce que** la durée de la au moins une impulsion inverse est ajustée à environ 1-10 ms.

10. Procédé selon l'une quelconque des revendications 6 à 9, **caractérisé en ce que** la densité maximale de courant de la au moins une impulsion avant sur la pièce à usiner est ajustée de préférence, à maximum 15 A/dm², de manière particulièrement préférée à 1,5-8 A/dm² pour un procédé horizontal et de manière particulièrement préférée à maximum 2A/dm² pour un procédé vertical.

11. Procédé selon l'une quelconque des revendications 6 à 9, **caractérisé en ce que** la densité maximale de courant de la au moins une impulsion inverse sur la pièce à usiner est ajustée de préférence, à maximum 60 A/dm², de manière particulièrement préférée à 30-50 A/dm² pour un procédé horizontal et de manière particulièrement préférée à 3-10 A/dm² pour un procédé vertical.

12. Procédé selon l'une quelconque des revendications 6 à 11, **caractérisé en ce qu'**une première tension sur un premier côté de la pièce à usiner et au moins une première anode est imposée, de sorte que le premier côté de la pièce à usiner soit alimenté d'un premier courant pulsé inversé, sachant que pendant chaque cycle de ce premier courant pulsé inversé, au moins une première impulsion avant et au moins une première impulsion inverse se produisent,
**en ce qu'**une deuxième tension entre un deuxième côté de la pièce à usiner et au moins une deuxième anode est imposée, de sorte que le deuxième côté de la pièce à usiner soit alimenté d'un deuxième courant pulsé inversé, sachant que pendant chaque cycle de ce deuxième courant pulsé inversé, au moins une deuxième impulsion avant et au moins une deuxième impulsion inverse se produisent.

13. Procédé selon la revendication 12, **caractérisé en ce que** la première impulsion de courant s'ajoute à la deuxième impulsion pour faire environ 180°.

14. Procédé selon l'une quelconque des revendications 1 à 13, **caractérisé en ce que** les trous présentent une hauteur maximale de 3,5 mm, une hauteur préférée allant de 0,025 mm à 1 mm et une hauteur particulièrement préférée allant de 0,05 mm à 0,5 mm.

15. Procédé selon l'une quelconque des revendications 1 à 13, **caractérisé en ce que** les trous présentent un diamètre maximal de 1000 µm, de préférence allant de 30 µm à 300 µm et de manière particulièrement préférée, allant de 60 µm à 150 µm.

16. Procédé selon l'une quelconque des revendications 1 à 15, **caractérisé en ce que** la pièce à usiner est une carte de circuits imprimés ou un autre support de montage électrique, en plaque.
